# FASCICULE DE BREVET EUROPEEN

(11) **EP 2 991 051 B1**
(45) Date de publication et mention de la délivrance du brevet: **27.02.2019**
(21) Numéro de dépôt: 15173557.8
(22) Date de dépôt: 24.06.2015
(51) Int. Cl.: G08B 13/12, H05K 1/03, H05K 1/16, H01B 7/32

(54) **AGENCEMENT DE CONTROLE ET/OU D'ALERTE D'UNE TENTATIVE DE VOL D'UN TRONÇON DE CABLE ELECTRIQUE**
ANORDNUNG ZUR ÜBERWACHUNG UND/ODER WARNMELDUNG EINES DIEBSTAHLVERSUCHS EINES STROMKABELABSCHNITTS
ARRANGEMENT FOR MONITORING AND/OR ALERTING OF AN ATTEMPTED THEFT OF AN ELECTRIC CABLE

(30) Priorité: 28.08.2014 FR 1458067
(43) Date de publication de la demande: 02.03.2016
(73) Titulaire: Nexans, 92400 Courbevoie (FR)
(72) Inventeur: POULIN, Nicolas, 62138 Auchy-les-Mines (FR)
(74) Mandataire: Lenne, Laurence

(56) Documents cités:
- EP-A1- 2 608 172
- WO-A1-02/08771
- WO-A2-2010/116319
- ES-A1- 2 446 847
- FR-A1- 2 997 508
- US-A1- 2005 275 397
- Siema Applications: "BTW Automatic Break Transmission in electrical Wire system", , juillet 2014 (2014-07), XP055241709, Internet Extrait de l'Internet: URL:http://www.vossloh-cogifer.com/media/d ownloads/pdfs/innotrans_2014_documents/FTC 32_BTW_EN_Lecture_seule_Mode_de_compatibil it.pdf [extrait le 2016-01-15]

## Description

L'invention concerne un agencement de contrôle et/ou d'alerte d'une tentative de vol d'un tronçon de câble électrique.

En particulier dans le cas de câble de transport d'énergie électrique avec des conducteurs en cuivre ou d'aluminium par exemple, le vol de câbles pose un problème majeur dans les installations, par exemple de type ferroviaire. Il cause des dégâts de matériels importants, nécessite une réparation et occasionne des arrêts et des retards de service.

L'invention se propose de résoudre ce problème en fournissant un agencement de contrôle et/ou d'alerte d'une tentative de vol d'un tronçon de câble électrique, assurant une surveillance continue d'un tel câble et sur toute sa longueur.

Si les documents de brevet WO 02/08771 ou US 2005/275397 décrivent un câble électrique comportant un conducteur entouré d'une couche isolante équipé d'un capteur inductif disposé autour de la couche isolante et connecté électriquement à un module électronique de gestion et de communication, ces documents divulguent des appareillages séparés du câble et destinés au contrôle de caractéristiques électriques du câble.

Par ailleurs, le document de brevet WO 2010/116319 décrit un agencement de contrôle et/ou d'alerte d'une tentative de vol d'un tronçon de câble électrique, comportant un câble électrique comportant au moins un conducteur entouré d'une couche isolante, comprenant au moins un module électronique de gestion et de communication et un système de contrôle et/ou d'alerte d'une tentative de vol d'un tronçon de ce câble connecté au dit module électronique.

Et le document de brevet FR 2 997 508 divulgue un câble électrique comportant au moins un conducteur entouré d'une couche isolante, comportant une pluralité de capteurs répartis sur sa longueur, chaque capteur étant connecté électriquement à un dit module électronique de gestion et de communication.

L'invention, quant à elle, propose un agencement de contrôle et/ou d'alerte d'une tentative de vol d'un tronçon de câble électrique, comportant un câble électrique comportant au moins un conducteur entouré d'une couche isolante, comprenant au moins un module électronique de gestion et de communication et un système de contrôle et/ou d'alerte d'une tentative de vol d'un tronçon de ce câble connecté au dit module électronique, agencement caractérisé en ce qu'il comprend au moins un capteur inductif disposé autour de ladite couche isolante, ledit module électronique de gestion et de communication étant connecté électriquement au dit capteur.

Ainsi, quand un objet coupant métallique, de type pince ou scie, est approché du câble, la proximité de cet objet peut être détectée par le capteur et le module de gestion et de communication. Il est ainsi possible de détecter la tentative de vol avant celui-ci.

Cet agencement ne comporte aucune pièce mécanique susceptible d'usure.

La disposition du capteur autour de ladite couche isolante assure une perturbation très limitée provoquée par le courant transporté par le(s) conducteur(s) du câble.

De préférence, le système de contrôle et/ou d'alerte d'une tentative de vol d'un tronçon de ce câble assure la mesure du temps d'émission d'un signal transmis par un dit module électronique de gestion et de communication.

Et avantageusement, ledit système de contrôle et/ou d'alerte d'une tentative de vol actionne une alarme, lorsque ce temps d'émission dépasse un laps de temps prédéterminé.

De préférence, ledit système de contrôle et/ou d'alerte d'une tentative de vol d'un tronçon de ce câble assure la traduction d'un signal transmis par un dit module électronique de gestion et de communication en indice de proximité d'un objet métallique et vérifie la diminution de cet indice.

L'invention concerne également un câble électrique d'un tel agencement de contrôle et/ou d'alerte, comportant au moins un conducteur entouré d'une couche isolante, comportant une pluralité de capteurs répartis sur sa longueur, chaque capteur étant connecté électriquement à un dit module électronique de gestion et de communication, caractérisé en ce que lesdits capteurs sont disposés autour de ladite couche isolante et ledit module électronique de gestion et de communication est disposé entre deux capteurs adjacents et également porté par ladite couche isolante.

De cette façon, la longueur complète du câble peut être surveillée et l'emplacement de la tentative de coupe peut être localisé.

De préférence, lesdits modules de gestion et de communication sont reliés par des câbles d'alimentation électrique et par des câbles de communication de données.

Lesdits câbles sont avantageusement disposés longitudinalement sur ladite couche isolante.

De préférence, le(s)dit(s) capteur(s) et le(s)dit(s) module(s) électronique de gestion et de communication sont recouverts d'une gaine externe isolante.

Il est ainsi obtenu un agencement étanche et isolé.

Chaque dit module électronique de gestion et de communication peut assurer l'alimentation électrique du capteur adjacent.

Chaque dit module électronique de gestion et de communication peut assurer la gestion d'une variation du champ électromagnétique détectée par le capteur adjacent.

Avantageusement, chaque capteur est une bobine constituée d'une spirale d'élément conducteur.

Dans ce cas, ledit module électronique de gestion et de communication peut assurer la détection d'une variation de l'intensité du courant dans ledit élément conducteur.

Ledit élément conducteur est de préférence en cuivre.

Avantageusement, l'élément conducteur est gravé sur un film flexible enroulé autour de ladite couche isolante du câble.

La bobine peut également être une spirale de fil conducteur.

De préférence, le câble est un câble de transport d'énergie électrique, mais l'invention peut également être utilisée pour des câbles de transmission de données.

L'invention est décrite ci-après plus en détail à l'aide de figures ne représentant qu'un mode de réalisation préféré de l'invention.

La figure 1 est une vue en perspective d'un câble selon l'invention.

La figure 2 est une vue schématique de détail de ce câble.

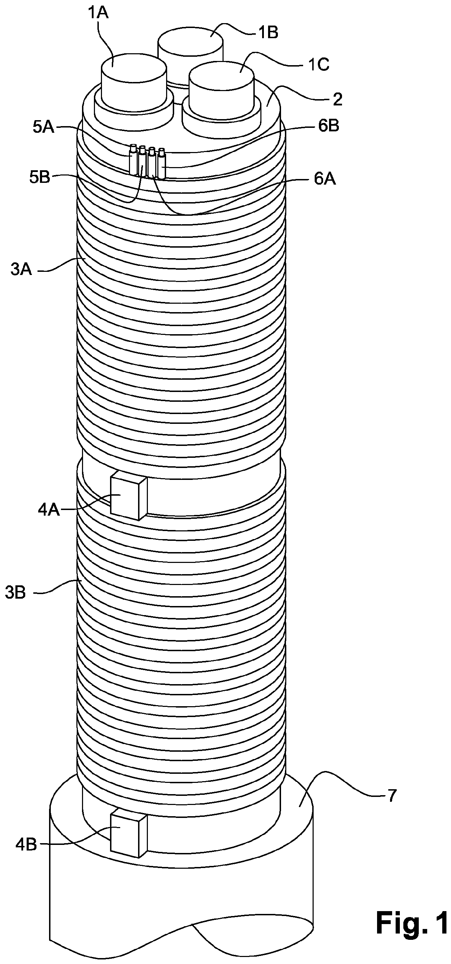

Comme représenté sur la figure 1, l'invention propose un câble triphasé de transport d'énergie électrique comportant trois conducteurs 1A, 1B, 1C isolés individuellement et dont l'ensemble est entouré d'une couche isolante 2.

Selon l'invention, au moins un capteur inductif est disposé autour de cette couche isolante 2 et est connecté électriquement à au moins un module électronique de gestion et de communication.

De préférence, le câble comporte une pluralité de capteurs 3A, 3B répartis sur sa longueur, chaque capteur étant connecté électriquement à un module électronique de gestion et de communication 4A, 4B disposé entre deux capteurs adjacents. Sur la figure seuls deux capteurs sont visibles.

Ces modules de gestion et de communication sont alimentés par deux câbles d'alimentation électrique 5A, 5B et sont reliés par deux câbles de communication de données 6A, 6B tous disposés longitudinalement sur la couche isolante 2.

Les deux câbles de communication de données assure d'une part une émission destinée à la transmission de module en module sur la longueur du câble, et d'autre part une réception, afin que, lors de la première mise sous tension, chaque module puisse recevoir l'adresse du module voisin pour pouvoir incrémenter son adresse, ou puisse recevoir un paramétrage particulier. Ils sont ici au nombre de deux, mais leur nombre peut varier selon le protocole utilisé.

L'alimentation en courant de ces câbles d'alimentation électrique 5A, 5B est de préférence réalisée en extrémité du câble de transport d'énergie électrique, mais peut également être effectué en tout point sur la longueur de ce câble.

Les capteurs et les modules électroniques de gestion et de communication sont recouverts d'une gaine externe isolante 7, ici représentée partiellement, les deux capteurs 3A, 3B étant représentés sans cette gaine.

Chaque module électronique de gestion et de communication 4A, 4B assure l'alimentation électrique du capteur adjacent 3A, 3B, l'alimentation électrique du module électronique de gestion et de communication suivant ainsi que la transmission de données au module électronique de gestion et de communication suivant, résultante de la gestion d'une variation du champ électromagnétique détectée par le capteur adjacent 3A, 3B.

La détection d'une variation du champ électromagnétique dans un capteur 3A, 3B est transmise à un système de contrôle et/ou d'alerte au moyen des modules électroniques de gestion et de communication 4A, 4B, l'information étant transmise de module en module jusqu'à l'extrémité du câble où est disposé et connecté ce système de contrôle et/ou d'alerte où cette variation du champ électromagnétique est traduite en indice de proximité de l'objet métallique et la diminution de cet indice est vérifié, représentatif d'un outil tel une pince en cours de fermeture sur le câble .

La distance de détection maximale est de préférence de l'ordre de un centimètre.

Afin d'éviter des alarmes intempestives, le système de contrôle et/ou d'alerte vérifie également que le capteur détecte une variation du champ électromagnétique pendant un certain laps de temps, par exemple de l'ordre de 500 millisecondes.

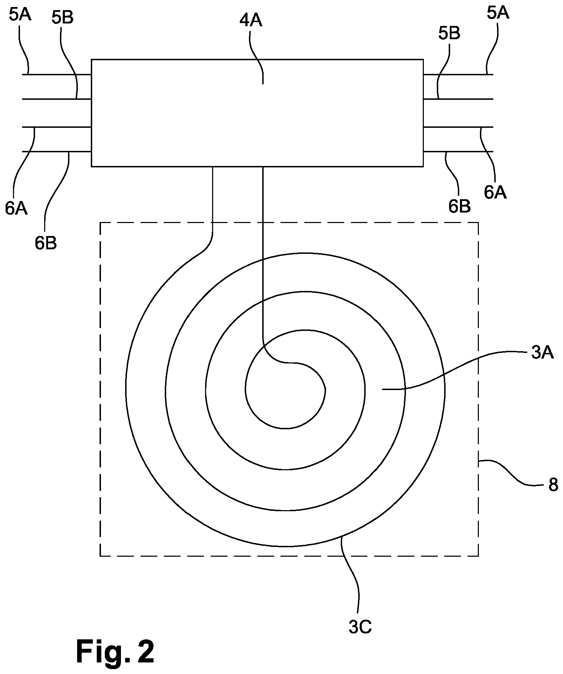

Comme mieux visible sur la figure 2, chaque capteur est une bobine 3 constituée d'une spirale d'élément conducteur 3C, de préférence en cuivre, afin de ne pas créer de courant induit qui nécessite alors un filtrage électronique.

Chaque module électronique de gestion et de communication assure alors la détection d'une variation de l'intensité du courant dans ledit élément conducteur 3C.

Avantageusement, l'élément conducteur 3C est gravé sur un film flexible 8 enroulé autour de la couche isolante 2 du câble, tel un circuit imprimé.

## Revendications

1. Agencement de contrôle et/ou d'alerte d'une tentative de vol d'un tronçon de câble électrique, comportant un câble électrique comportant au moins un conducteur (1A, 1B) entouré d'une couche isolante (2), comprenant au moins un module électronique de gestion et de communication (4A, 4B) et un système de contrôle et/ou d'alerte d'une tentative de vol d'un tronçon de ce câble connecté au dit module électronique, agencement **caractérisé en ce qu'**il comprend au moins un capteur inductif (3A, 3B) disposé autour de ladite couche isolante (2), ledit module électronique de gestion et de communication (4A, 4B) étant connecté électriquement au dit capteur (3A, 3B).

2. Agencement selon la revendication 1, **caractérisé en ce que** le système de contrôle et/ou d'alerte d'une tentative de vol d'un tronçon de ce câble assure la mesure du temps d'émission d'un signal transmis par un dit module électronique de gestion et de communication (4A, 4B).

3. Agencement selon la revendication 2, **caractérisé en ce que** ledit système de contrôle et/ou d'alerte d'une tentative de vol actionne une alarme, lorsque ce temps d'émission dépasse un laps de temps prédéterminé.

4. Agencement selon l'une des revendications précédentes, **caractérisé en ce que** ledit système de contrôle et/ou d'alerte d'une tentative de vol d'un tronçon de ce câble assure la traduction d'un signal transmis par un dit module électronique de gestion et de communication (4A, 4B) en indice de proximité d'un objet métallique et vérifie la diminution de cet indice.

5. Câble électrique d'un agencement de contrôle et/ou d'alerte selon l'une des revendications précédentes, comportant au moins un conducteur (1A, 1B) entouré d'une couche isolante (2), comportant une pluralité de capteurs (3A, 3B) répartis sur sa longueur, chaque capteur (3A, 3B) étant connecté électriquement à un dit module électronique de gestion et de communication (4A, 4B), **caractérisé en ce que** lesdits capteurs (3A, 3B) sont disposés autour de ladite couche isolante (2) et ledit module électronique de gestion et de communication (4A, 4B) est disposé entre deux capteurs (3A, 3B) adjacents et également porté par ladite couche isolante (2).

6. Câble selon la revendication précédente, **caractérisé en ce que** lesdits modules de gestion et de communication (4A, 4B) sont reliés par des câbles d'alimentation électrique (5A, 5B) et par des câbles de communication de données (6A, 6B).

7. Câble selon la revendication précédente, **caractérisé en ce que** lesdits câbles (5A, 5B, 6A, 6B) sont disposés longitudinalement sur ladite couche isolante (2).

8. Câble selon l'une des revendications 5 à 7, **caractérisé en ce que** le(s)dit(s) capteur(s) (3A, 3B) et le(s)dit(s) module(s) électronique(s) de gestion et de communication (4A, 4B) sont recouverts d'une gaine externe isolante (7).

9. Câble selon l'une des revendications 5 à 8, **caractérisé en ce que** chaque dit module électronique de gestion et de communication (4A, 4B) assure l'alimentation électrique du capteur (3A, 3B) adjacent.

10. Câble selon l'une des revendications 5 à 9, **caractérisé en ce que** chaque dit module électronique de gestion et de communication (4A, 4B) assure la gestion d'une variation du champ électromagnétique détectée par le capteur capteur (3A, 3B) adjacent.

11. Câble selon l'une des revendications 5 à 10, **caractérisé en ce que** chaque capteur (3A, 3B) est une bobine constituée d'une spirale d'élément conducteur (3C).

12. Câble selon la revendication précédente, **caractérisé en ce que** ledit module électronique de gestion et de communication assure la détection d'une variation de l'intensité du courant dans ledit élément conducteur (3C).

13. Câble selon la revendication 11 ou 12, **caractérisé en ce que** ledit l'élément conducteur (3C) est en cuivre.

14. Câble selon l'une des revendications 11 à 13, **caractérisé en ce que** l'élément conducteur (3C) est gravé sur un film flexible (8) enroulé autour de ladite couche isolante (2) du câble.

15. Câble selon l'une des revendications 5 à 14, **caractérisé en ce que** le câble est un câble de transport d'énergie électrique.

## Patentansprüche

1. Anordnung zur Überwachung und/oder Warnmeldung eines Diebstahlversuchs eines Stromkabelabschnitts, umfassend ein elektrisches Kabel, umfassend mindestens einen Leiter (1A, 1B), der von einer isolierenden Schicht (2) umgeben ist, umfassend mindestens ein elektronisches Modul zur Verwaltung und zur Kommunikation (4A, 4B) und ein System zur Überwachung und/oder Warnmeldung eines Diebstahlversuchs eines Stromkabelabschnitts, das mit dem elektronischen Modul verbunden ist, Anordnung, die **dadurch gekennzeichnet ist, dass** sie mindestens einen induktiven Sensor (3A, 3B) umfasst, der um die isolierende Schicht (2) angeordnet ist, wobei das elektronische Modul zur Verwaltung und zur Kommunikation (4A, 4B) elektrisch mit dem Sensor (3A, 3B) verbunden ist.

2. Anordnung nach Anspruch 1, **dadurch gekennzeichnet, dass** das System zur Überwachung und/oder Warnmeldung eines Diebstahlversuchs eines Stromkabelabschnitts die Messung der Emissionszeit eines Signals, das von einem elektronischen Modul zur Verwaltung und zur Kommunikation (4A, 4B) übertragen wird, sicherstellt.

3. Anordnung nach Anspruch 2, **dadurch gekennzeichnet, dass** das System zur Überwachung und/oder Warnmeldung eines Diebstahlversuchs einen Alarm betätigt, wenn diese Emissionszeit einen vorbestimmten Zeitraum übersteigt.

4. Anordnung nach einem der vorhergehenden Ansprüche, **dadurch gekennzeichnet, dass** das System zur Überwachung und/oder Warnmeldung eines Diebstahlversuchs eines Stromkabelabschnitts die Weitergabe eines Signals, das von dem elektronischen Modul zur Verwaltung und zur Kommunikation (4A, 4B) übertragen wird, davon die Nähe eines metallischen Gegenstands angibt und die Verringerung dieser Angabe verifiziert.

5. Elektrisches Kabel einer Anordnung zur Überwachung und/oder Warnmeldung nach einem der vorhergehenden Ansprüche, umfassend mindestens einen Leiter (1A, 1B), der von einer isolierenden Schicht (2) umgeben ist, umfassend eine Vielzahl von Sensoren (3A, 3B), die auf ihrer Länge verteilt sind, wobei jeder Sensor (3A, 3B) elektrisch mit einem elektronischen Modul zur Verwaltung und zur Kommunikation (4A, 4B) verbunden ist, **dadurch gekennzeichnet, dass** die Sensoren (3A, 3B) um die isolierende Schicht (2) angeordnet sind und das elektronische Modul zur Verwaltung und zur Kommunikation (4A, 4B) zwischen zwei benachbarten Sensoren (3A, 3B) angeordnet ist und auch von der isolierenden Schicht (2) getragen ist.

6. Kabel nach dem vorhergehenden Anspruch, **dadurch gekennzeichnet, dass** die Module zur Verwaltung und zur Kommunikation (4A, 4B) durch Kabel zur elektrischen Versorgung (5A, 5B) und durch Kabel zur Kommunikation von Daten (6A, 6B) verbunden sind.

7. Kabel nach dem vorhergehenden Anspruch, **dadurch gekennzeichnet, dass** die Kabel (5A, 5B, 6A, 6B) längs gerichtet auf der isolierenden Schicht (2) angeordnet sind.

8. Kabel nach einem der Ansprüche 5 bis 7, **dadurch gekennzeichnet, dass** der/die Sensor(en) (3A, 3B) und das/die elektronisch(en) Modul(e) zur Verwaltung und zur Kommunikation (4A, 4B) mit einer isolierenden äußeren Umhüllung (7) abgedeckt sind.

9. Kabel nach einem der Ansprüche 5 bis 8, **dadurch gekennzeichnet, dass** jedes elektronische Modul zur Verwaltung und zur Kommunikation (4A, 4B) die elektrische Versorgung des benachbarten Sensors (3A, 3B) sicherstellt.

10. Kabel nach einem der Ansprüche 5 bis 9, **dadurch gekennzeichnet, dass** jedes elektronische Modul zur Verwaltung und zur Kommunikation (4A, 4B) die Verwaltung einer Variation des elektromagnetischen Feldes sicherstellt, das vom benachbarten Sensor (3A, 3B) nachgewiesen wurde.

11. Kabel nach einem der Ansprüche 5 bis 10, **dadurch gekennzeichnet, dass** jeder Sensor (3A, 3B) eine Spule ist, die aus einer Spirale eines leitenden Elements (3C) besteht.

12. Kabel nach dem vorhergehenden Anspruch, **dadurch gekennzeichnet, dass** das elektronische Modul zur Verwaltung und zur Kommunikation den Nachweis einer Variation der Intensität des Stroms in dem leitenden Element (3C) sicherstellt.

13. Kabel nach Anspruch 11 oder 12, **dadurch gekennzeichnet, dass** das leitende Element (3C) aus Kupfer ist.

14. Kabel nach einem der Ansprüche 11 bis 13, **dadurch gekennzeichnet, dass** das leitende Element (3C) auf einen flexiblen Film (8) eingraviert ist, der um die isolierende Schicht (2) des Kabels gerollt ist.

15. Kabel nach einem der Ansprüche 5 bis 14, **dadurch gekennzeichnet, dass** das Kabel ein Kabel zum Transport von elektrischer Energie ist.

## Claims

1. An arrangement for monitoring and/or alerting of an attempted theft of an electric cable, including an electric cable including at least one conductor (1A, 1B) surrounded by an insulating layer (2), comprising at least one electronic management and communication module (4A, 4B) and a system for monitoring and/or alerting of an attempted theft of a section of said cable connected to said electronic module, the arrangement being **characterized in that** it comprises at least one inductive sensor (3A, 3B) arranged around said insulating layer (2), said electronic management and communication module (4A, 4B) being electrically connected to said sensor (3A, 3B).

2. The arrangement according to claim 1, **characterized in that** the system for monitoring and/or alerting of an attempted theft of a section of said cable provides the measurement of the emission time of the signal transmitted by one said electronic management and communication module (4A, 4B).

3. The arrangement according to claim 2, **characterized in that** said system for monitoring and/or alerting of an attempted theft actuates an alarm, when said emission time exceeds a predetermined length of time.

4. The arrangement according to one of the preceding claims, **characterized in that** said system for monitoring and/or alerting of an attempted theft of a section of said cable provides the translation of a signal transmitted by one said electronic management and communication module (4A, 4B) into a proximity index of a metal object and verifies the decrease of said index.

5. An electric cable of a monitoring and/or alert arrangement according to one of the preceding claims, including at least one conductor (1A, 1B) surrounded by an insulating layer (2), including a plurality of sensors (3A, 3B) distributed over its length, each sensor (3A, 3B) being electrically connected to one said electronic management and communication module (4A, 4B), **characterized in that** said sensors (3A, 3B) are positioned around said insulating layer (2) and said electronic management and communication module (4A, 4B) is positioned between two adjacent sensors (3A, 3B) and also carried by said insulating layer (2).

6. The cable according to the preceding claim, **characterized in that** said management and communication modules (4A, 4B) are connected by power cables (5A, 5B) and by data communication cables (6A, 6B).

7. The cable according to the preceding claim, **characterized in that** said cables (5A, 5B, 6A, 6B) are positioned longitudinally on said insulating layer (2).

8. The cable according to one of claims 5 to 7, **characterized in that** said sensor(s) (3A, 3B) and said electronic management and communication module(s) (4A, 4B) are covered by an insulating outer sheath (7).

9. The cable according to one of claims 5 to 8, **characterized in that** each said electronic management and communication module (4A, 4B) provides the electrical power supply of the adjacent sensor (3A, 3B).

10. The cable according to one of claims 5 to 9, **characterized in that** each said electronic management and communication module (4A, 4B) provides the management of a variation of the electromagnetic field detected by the adjacent sensor (3A, 3B).

11. The cable according to one of claims 5 to 10, **characterized in that** each sensor (3A, 3B) is a coil made up of a spiral of conductive element (3C).

12. The cable according to the preceding claim, **characterized in that** said electronic management and communication module provides the detection of a variation in the intensity of the current in said conductive element (3C).

13. The cable according to claim 11 or 12, **characterized in that** said conductive element (3C) is made from copper.

14. The cable according to one of claims 11 to 13, **characterized in that** the conductive element (3C) is etched on a flexible film (8) wound around said insulating layer (2) of the cable.

15. The cable according to one of claims 5 to 14, **characterized in that** the cable is an electrical energy transport cable.
